# EUROPÄISCHE PATENTSCHRIFT

(11) **EP 1 035 650 B1**
(45) Veröffentlichungstag und Bekanntmachung des Hinweises auf die Patenterteilung: **27.07.2005**
(21) Anmeldenummer: 00104779.4
(22) Anmeldetag: 06.03.2000
(51) Int. Cl.: H03J 9/06

(54) **Ferngesteuertes elektronisches Gerät**
A remotely controlled electronic apparatus
Appareil électronique commandé à distance

(30) Priorität: 05.03.1999 DE 19909656
(43) Veröffentlichungstag der Anmeldung: 13.09.2000
(73) Patentinhaber: ROBERT BOSCH GMBH, 70442 Stuttgart (DE)
(72) Erfinder: Rychlak, Stefan, 31241 Ilsede (DE)

(56) Entgegenhaltungen:
- DE-A- 4 323 204
- US-A- 4 633 514

## Beschreibung

Die Erfindung betrifft ein ferngesteuertes elektronisches Gerät mit einer Tastatur zur Bedienung des Gerätes, wobei die Tastatur ein Leitungsmatrix mit Tastern zur Schaltverbindung von jeweiligen Leitungen der Leitungsmatrix aufweist, und mit einem Empfänger für ein Fernsteuersignal zur Fernbedienung des Gerätes. Die Erfindung ist vorzugsweise zur Infrarot-Fernsteuerung von Autoradios geeignet.

Herkömmliche elektronische Geräte, insbesondere Autoradios, mit einem Infrarotempfänger zur Fernsteuerung des elektronischen Gerätes haben Datenschnittstellen, an die der Infrarotempfänger angeschlossen wird. Diese Datenschnittstellen sind an den Prozessorbaustein des Gerätes gekoppelt und können oftmals nur für eine einzige Steuereinheit oder eine einzige Datenverbindung zu peripheren Geräten verwendet werden, siehe z.b. US-A-4633514.

Aufgabe der Erfindung war es, ein ferngesteuertes elektronisches Gerät zu schaffen, wobei die Fernsteuereinheit keine Schnittstelle belegt und keine zusätzliche spezielle Fernsteuerschnittstelle erfordert.

Die Erfindung wird durch das gattungsgemäße ferngesteuerte elektronische Gerät mit den Merkmalen des Patentanspruchs 1 dadurch gelöst, daß mindestens eine Schalteinheit in die Leitungsmatrix zur Schaltverbindung von jeweiligen Leitungen geschaltet ist und der Empfänger mit einem Steuereingang der mindestens einen Schalteinheit verbunden ist.

Damit wird vorteilhafterweise die Tastatur als Steuerschnittstelle zusätzlich genutzt. Hierzu werden Schaltimpulse des Empfängers zur Ansteuerung von Schalteinheiten, z.B. von Schalttransistoren, verwendet, die in die Leitungsmatrix eingearbeitet sind. Diese Schalteinheiten können entweder in eigenständige Leitungsstränge der Leitungsmatrix oder parallel zu entsprechenden Tastern geschaltet sein. Durch die Ankoppelung des Fernsteuersignal-Empfängers über die Tastaturmatrix wird vorteilhafterweise kein zusätzlicher Anschluß eines Geräteprozessors für die Fernsteuerung benötigt und es wird keine Schnittstelle belegt.

Die Tastaturmatrix wird vorteilhafterweise mit einer bekannten Tasturauswerteeinheit ausgewertet, wobei die Tastaturauswerteeinheit das Auslesen von festgelegten Tastern unterdrückt, wenn ein Fernsteuersignal erkannt ist. Dieses Austasten bzw. Verriegeln der ausgewählten Taster ist insbesondere dann erforderlich, wenn das Fernsteuersignal ein Pulsweitensignal ist, so daß im Vergleich zu Tastersignalen längere digitale "Null"- oder "Eins"-Signale erkannt werden müssen. Dann sind Verzögerungszeiten vorzusehen, in denen die Abfrage der Taster unterdrückt wird.

Die Erfindung ist vorzugsweise zur Infrarotsteuerung von elektronischen Geräten und insbesondere von Autoradios geeignet.

Die Erfindung wird nachfolgend anhand der beigefügten Zeichnung erläutert. Es zeigt:

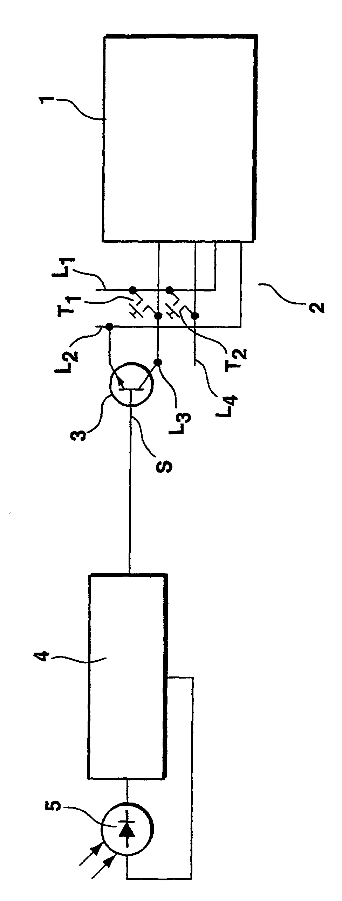

- Figur 1 -: Schaltskizze des ferngesteuerten elektronischen Gerätes.

Wie aus der Schaltskizze des ferngesteuerten elektronischen Gerätes in der Figur 1 ersichtlich ist, hat das elektronische Gerät eine Tastaturauswerteeinheit 1, zum Auswerten von Tastatursignalen und Steuern des elektronischen Gerätes. An die Tastaturauswerteeinheit 1 ist eine Leitungsmatrix 2 geschaltet, die in bekannter Weise Taster T1, T2 zur Schaltverbindung von jeweiligen Leitungen L der Leitungsmatrix 2 aufweist. Die Tastaturauswerteeinheit 1 kann z.B. ein Geräteprozessor oder ein Tastaturtreiber sein. In dem dargestellten Beispiel ist eine zusätzliche Leitung L2 vorgesehen, an die eine Schalteinheit T z.B. ein Schalttransistor 3 geschaltet ist. Der Schalttransistor 3 wird durch einen Empfänger 4 z.B. einem Infrarotempfänger, gesteuert, indem dieser an die Basis des Schalttransistors gekoppelt ist, welcher den Steuereingang S des Schaltelements 3 bildet. Der Infrarotempfänger 4 hat eine Infrarotdiode 5 zum Empfangen von Infrarot-Fernsteuersignalen. Wenn ein Infrarot-Fernsteuersignal erkannt wird, liegt an dem Ausgang des Infrarotempfängers 4 ein Pulsweitensignal an und der Schalttransistor 3 wird über seine Basis durchgeschaltet. Dadurch werden die jeweiligen Leitungen L der Leitungsmatrix 2 miteinander verbunden und von dem Geräteprozessor 1 bzw. dem Tastaturtreiber wird ein digitales "Null"-Signal erkannt. Dieses Signal hat im Vergleich zu den herkömmlichen entprellten Tastern T1, T2 eine längere Zeitdauer. Daher ist es erforderlich, daß die Tastaturauswerteeinheit 1 mittels des Geräteprozessors oder des Tastaturtreibers das Auslesen von ausgewählten Tastern oder sämtlicher Taster und gegebenenfalls von weiteren Schalttransistoren 3 unterdrückt, sobald ein Infrarotsignal erkannt wurde. Hierzu kann eine Verzögerungseinheit vorgesehen sein, die anspricht, sobald das Infrarot-Signal erkannt wurde.

Das ferngesteuerte elektronische Gerät kann eine Vielzahl von entsprechend geschalteten Schalttransistoren 3 und Tastern T1, T2 haben. Zur Ansteuerung der mehreren Schalttransistoren 3 kann der Infrarotempfänger eine entsprechende Anzahl von Schaltausgängen aufweisen. Es können aber auch mehrere voneinander unabhängige Infrarotempfänger verwendet werden.

Das beschriebene ferngesteuerte elektronische Gerät ist vorzugsweise ein Autoradio, bei dem die Anzahl der verfügbaren sonstigen Schnittstellen aus räumlichen und schaltungstechnischen Gründen begrenzt ist.

Das Fernsteuersignal ist in dem beschriebenen Beispiel eine Infrarotsignal Gleichermaßen können aber auch andere Fernsteuerungen, wie zum Beispiel Ultraschallsteuerung, Audiosteuerung oder Funksteuerung verwendet werden.

## Patentansprüche

1. Ferngesteuertes elektronisches Gerät mit einer Tastatur zur Bedienung des Gerätes, wobei die Tastatur eine Leitungsmatrix (2) mit Tastern (T1, T2) zur Schaltverbindung von jeweiligen Leitungen (2) der Leitungsmatrix (2) aufweist, und mit einem Empfänger (4) für ein Fernsteuersignal, **dadurch gekennzeichnet, daß** mindestens eine Schalteinheit (3) in die Leitungsmatrix (2) zur Schaltverbindung von jeweiligen Leitungen (L) geschaltet ist und der Empfänger (3) mit einem Steuereingang (S) der mindestens einen Schalteinheit (3) verbunden ist.

2. Ferngesteuertes elektronisches Gerät nach Anspruch 1, wobei eine Tastaturauswerteeinheit (1) zum Auswerten der Signale der Leitungsmatrix (2) vorgesehen ist, **dadurch gekennzeichnet, daß** die Tastaturauswerteeinheit (1) das Auslesen von festgelegten Tastern (T1, T2) unterdrückt, wenn ein Fernsteuersignal erkannt ist.

3. Ferngesteuertes elektronisches Gerät nach Anspruch 1 oder 2, **dadurch gekennzeichnet, daß** das Fernsteuersignal ein Infrarotsignal und der Empfänger (4) ein Infrarotempfänger ist.

4. Ferngesteuertes elektronisches Gerät nach einem der vorhergehenden Ansprüche, **dadurch gekennzeichnet, daß** die Steuereinheit (3) ein Schalttransistor ist.

5. Ferngesteuertes elektronisches Gerät nach einem der vorhergehenden Ansprüche, **dadurch gekennzeichnet, daß** das elektronische Gerät ein Autoradio ist.

## Claims

1. Remote-controlled electronic device having a keypad for operating the device, wherein the keypad has a line matrix (2) with keys (T1, T2) for the switching connection of respective lines (L) of the line matrix (2), and having a receiver (4) for a remote-control signal, **characterized in that** at least one switching unit (3) is connected in the line matrix (2) for the switching connection of respective lines (L), and the receiver (4) is connected to a control input (S) of the at least one switching unit (3).

2. Remote-controlled electronic device according to Claim 1, wherein a keypad evaluation unit (1) is provided for evaluating the signals of the line matrix (2), **characterized in that** the keypad evaluation unit (1) prevents defined keys (T1, T2) from being selected when a remote-control signal is detected.

3. Remote-controlled electronic device according to Claim 1 or 2, **characterized in that** the remote-control signal is an infrared signal and the receiver (4) is an infrared receiver.

4. Remote-controlled electronic device according to one of the preceding claims, **characterized in that** the control unit (3) is a switching transistor.

5. Remote-controlled electronic device according to one of the preceding claims, **characterized in that** the electronic device is a car radio.

## Revendications

1. Appareil électronique commandé à distance comportant pour commander l'appareil,
- un clavier présentant une matrice de lignes (2) munie de boutons poussoirs (T1, T2) pour relier par commutation chacune des lignes de la matrice (2), et
- un récepteur (4) pour un signal de télécommande,
**caractérisé en ce qu'**
au moins une unité de commutation (3) est connectée dans la matrice de lignes (2) pour la liaison de chaque ligne (L) par commutation et
le récepteur (4) est relié à une entrée de commande (S) de l'au moins une unité de commutation (3).

2. Appareil électronique commandé à distance selon la revendication 1, dans lequel on prévoit une unité d'exploitation du clavier (1) pour exploiter les signaux de la matrice de lignes (2),
**caractérisé en ce que**
l'unité d'exploitation du clavier (1) empêche l'expression de boutons poussoirs (T1, T2) déterminés lorsqu'un signal de télécommande est détecté.

3. Appareil électronique commandé à distance selon la revendication 1 ou 2,
**caractérisé en ce que**
le signal de télécommande est un signal infrarouge et le récepteur (4) est un récepteur à infrarouge.

4. Appareil électronique commandé à distance selon l'une des revendications précédentes,
**caractérisé en ce que**
l'unité de commande (3) est un transistor de commutation.

5. Appareil électronique commandé à distance selon l'une des revendications précédentes,
**caractérisé en ce que**
l'appareil électronique est un autoradio.
